# DEMANDE DE BREVET EUROPEEN

(11) **EP 4 618 134 A1**
(43) Date de publication de la demande: **17.09.2025**
(21) Numéro de dépôt: 25162348.4
(22) Date de dépôt: 07.03.2025
(51) Int. Cl.: H01L 21/02

(54) **PROCÉDÉ DE FABRICATION D'UNE STRUCTURE VERTICALE DE NITRURE DE GALLIUM ET D'UN DISPOSITIF BASÉ SUR CETTE STRUCTURE**

(30) Priorité: 15.03.2024 FR 2402618
(71) Demandeur: SOITEC, 38190 Bernin (FR)
(72) Inventeur: KONONCHUK, Oleg, 38190 BERNIN (FR)
(74) Mandataire: IP Trust

(57) **Abrégé**

Procédé de fabrication d'une structure (Stck3) comprenant une pluralité de couches de GaN (GaN(n+)_1, Gan(p-), GaN(n-)_DL, GaN(n+)_2)) et prévue pour former un dispositif GaN vertical, comprenant les étapes de : fournir (110) un premier substrat (Sub1) ; former (130) une couche de GaN de nucléation (Nuc) sur le premier substrat (Sub1) ; former (150) par épitaxie un empilement (Stck1) comprenant une pluralité de couches de GaN sur la couche de nucléation ; sur l'empilement (Stck1), former (170) une première couche métallique (M1) ; fournir (120) un second substrat (Sub2) sur lequel on forme (140) une seconde couche métallique (M2) ; assembler (200) l'empilement (Stck1) au second substrat (Sub2) par mise en contact direct et collage des deux couches métalliques (M1, M2) ; détacher (210) le premier substrat (Sub1) de l'empilement (Stck1) au niveau de la couche de nucléation (Nuc) par irradiation lumineuse à travers le premier substrat (Sub1).

## Description

### DOMAINE TECHNIQUE DE L'INVENTION

L'invention concerne un procédé de fabrication d'une structure verticale de nitrure de gallium incluant une étape de report de couches sur un substrat. Cette structure verticale de nitrure de gallium est également employée pour former un dispositif semiconducteur dont un composant actif est constitué de la couche de nitrure de gallium.

### ARRIERE PLAN TECHNOLOGIQUE

Parmi les matériaux semiconducteurs, le nitrure de gallium GaN est considéré comme une alternative au silicium Si pour de nombreuses applications. Les tensions de claquage très élevées, la grande mobilité des électrons et la vitesse de saturation du GaN en font un candidat idéal pour les applications à hautes fréquences, haute puissance, avec une vitesse de commutation élevée.

La large bande interdite du GaN signifie aussi que les performances des transistors GaN sont maintenues à des températures plus élevées que celles des transistors en silicium, car elle atténue les effets de la génération thermique de porteurs de charge inhérents à tout semiconducteur. Ainsi, les dispositifs semiconducteurs à base de GaN présentent une relative immunité à la température par rapport au silicium.

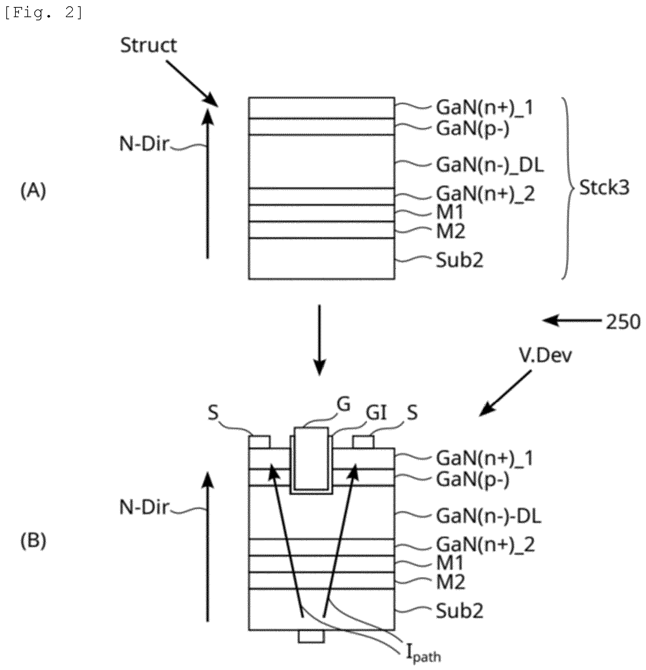

Les dispositifs semiconducteurs à base de GaN peuvent présenter une grande variété de structures. Parmi ces structures, on parle de dispositif GaN horizontal lorsque le courant parcourant le dispositif suit un chemin situé sensiblement dans au plan d'extension des couches superposées formant le dispositif. A l'inverse, on parle de dispositif GaN vertical lorsque le courant parcourant le dispositif suit un chemin sensiblement perpendiculaire au plan d'extension des couches superposées formant le dispositif, comme illustré par le courant Iₚₐₜₕ de la figure 2. On pourra par exemple se reporter à l'article de Langpoklakpam et al., « Vertical GaN MOSFET Power Devices », Micromachines 2023, 14, 1937.

Deux approches sont employées pour réaliser des dispositifs GaN verticaux, appliqués par exemple aux transistors à effet de champ, aux diodes à jonction pn ou aux diodes Shottky. Les deux approches résultent en des dispositifs formés d'un empilement de couches semiconductrices de GaN et de prises de contacts électriques métalliques réparties sur les deux faces du dispositif. Les prises de contact peuvent par exemple consister en une paire d'anode et de cathode sur deux faces opposées d'un dispositif redresseur de tension, ou en une électrode de grille et une ou plusieurs électrodes de source sur une première face d'un transistor à effet de champ et une électrode de drain sur la face opposée du transistor.

Une première approche pour l'obtention de telles structures comprend des dépôts par épitaxie des couches semiconductrices GaN sur une substrat formé d'un wafer de silicium ou d'une structure composite comprenant une couche supérieure formée de silicium. Dans une seconde approche, un substrat de GaN massif peut être employé.

La première approche se traduit par des couches ayant des densités de dislocations (TDD pour Threading Dislocation Density en terminologie anglaise) élevée et des problèmes de conductivité thermique et électrique. La seconde approche requiert des plaquettes de GaN très coûteuses qui ne sont pas disponibles dans de grands diamètres, et la gestion thermique pose toujours problème.

### EXPOSE DE L'INVENTION

Un objet de l'invention est de fournir un procédé de fabrication d'un dispositif GaN vertical résolvant les problèmes mentionnés ci-dessus.

En vue de la réalisation de ces objets, un aspect de l'invention est un procédé de fabrication d'une structure comprenant une pluralité de couches de GaN, cette structure étant prévue pour former un dispositif GaN vertical, le procédé comprenant les étapes de fournir un premier substrat ; former une couche de GaN de nucléation sur une face du premier substrat ; sur la couche de GaN de nucléation, former par épitaxie un empilement comprenant une pluralité de couches de GaN ; sur l'empilement, former une première couche métallique de collage ; fournir un second substrat ; sur le second substrat, former une seconde couche métallique de collage ; assembler l'empilement au second substrat par mise en contact direct et collage métallique des deux couches métalliques de collage ; détacher le premier substrat de l'empilement au niveau de la couche de nucléation par irradiation lumineuse à travers le premier substrat et absorption de cette irradiation par la couche de nucléation ; et éliminer la couche de nucléation.

Le procédé selon l'invention permet de produire une structure semiconductrice formée de nitrure de gallium GaN de haute qualité cristalline sans employer de substrat massif de nitrure de gallium. Un avantage immédiat de ce procédé est donc une meilleure intégration, éventuellement sur des substrats de grandes dimensions non limitées par celles d'un wafer de GaN, d'un dispositif GaN vertical d'excellente qualité, et ce à un coût maîtrisé.

En outre, ce procédé est simple à mettre en œuvre, l'ensemble des couches formant l'empilement de couches de GaN étant formé successivement du côté des faces de désignation cristallographique (0001) des couches de GaN. L'ensemble du procédé ne requiert qu'un seul report de couche - un collage de l'empilement sur un second substrat suivi du décollage du premier substrat sur lequel l'empilement a initialement été formé, sans nécessiter de traitement mécanochimique de polissage pour éliminer le premier substrat. Ainsi, avec un seul report de couche, ce procédé permet d'obtenir une structure avec des surfaces des couches de GaN orientées à l'opposé du second substrat.

Selon des caractéristiques additionnelles non-limitative de l'invention, considérées individuellement ou selon toute combinaison techniquement réalisable :
- le second substrat peut être formé de carbure de silicium polycristallin ;
- l'étape d'éliminer la couche de nucléation peut comprendre également une élimination d'une partie de celle des couches de GaN qui a été formée en contact direct avec la couche de nucléation ;
- l'étape d'éliminer la couche de nucléation peut être mise en œuvre par polissage mécano-chimique ;
- la couche de GaN de nucléation peut avoir une face libre de désignation cristallographique (0001) ;
- la couche de nucléation peut être formée par ALD - Atomic Layer Deposition en terminologie anglaise ;
- chacune des couches de GaN de l'empilement peut être formée sur et en contact direct avec une face de désignation cristallographique (0001) d'une couche de GaN précédemment déposée ;
- chacune des couches de GaN de l'empilement et de la couche de GaN de nucléation peut être formée de manière à présenter, juste après sa formation, une face libre de désignation cristallographique (0001) ;
- le premier substrat peut être un wafer de saphir ;
- la formation de l'empilement peut comprendre, dans cet ordre, la formation par épitaxie d'une première couche de GaN de type n+, d'une couche de GaN de type p-, d'une couche de GaN de type n-, et d'une seconde couche de GaN de type n+ ;
- le second substrat peut être un wafer de carbure de silicium, de préférence un wafer de carbure de silicium polycristallin de type n+ pouvant présenter une résistivité électrique inférieure à 10 mOhm.cm ;
- le procédé peut en outre comprendre l'étape de former :- une électrode de drain sur une face libre du second substrat ; une électrode de source sur une face libre de la première couche de GaN de type n+ ; et une structure de grille traversant la première couche de GaN de type n+, la couche de GaN de type p-, et en contact avec la couche de GaN de type n-.

Un premier avantage supplémentaire du procédé selon l'invention est la possibilité d'une meilleure gestion thermique du dispositif lorsque celui-ci est intégré sur un substrat de haute conductivité thermique tel qu'un substrat de carbure de silicium SiC.

Un second avantage supplémentaire du procédé est qu'après le collage métal-métal, il ne requiert pas de traitement thermique à haute température, limitant donc le budget thermique d'un dispositif en cours de fabrication et augmentant sa compatibilité avec des procédés d'intégration.

Un troisième avantage supplémentaire du procédé est que le stack comprenant les couches de nitrure de gallium peut être facilement détaché de son substrat par irradiation lumineuse en limitant les effets non-contrôlés sur la structure lors de l'irradiation lumineuse, et ceci grâce à la proximité entre la couche absorbant cette radiation et le substrat.

### BREVE DESCRIPTION DES FIGURES

D'autres caractéristiques et avantages de l'invention ressortiront de la description détaillée de l'invention qui va suivre en référence aux figures annexées sur lesquels :
D'autres caractéristiques et avantages de l'invention ressortiront de la description détaillée de l'invention qui va suivre en référence aux figures annexées sur lesquels :
[Fig. 1] La figure 1 illustre un procédé de fabrication d'une structure comprenant une pluralité de couches de GaN ;
[Fig. 2] La figure 2 illustre une structure obtenue selon le procédé illustré par la figure 1 et un dispositif obtenu à partir de cette structure ; et
[Fig. 3] La figure 3 illustre les procédés de fabrication de la structure et du dispositif illustrés par la figure 2.

### DESCRIPTION DETAILLEE DE L'INVENTION

### Mode de réalisation de l'invention

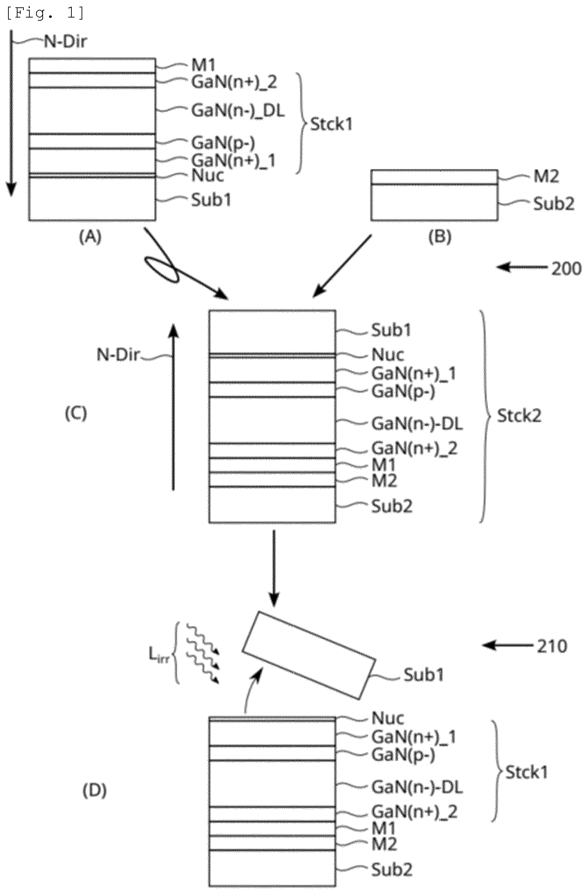

Un mode de réalisation de l'invention est décrit à l'aide des figures 1 à 3.

La figure 2 illustre en (A) une structure Struct comprenant une pluralité de couches de nitrure de gallium GaN et qui est prévue pour être utilisée pour former ultérieurement un dispositif GaN vertical. Chaque couche de nitrure de gallium GaN présente une structure cristallographique à maille hexagonale, notamment une structure cristallographique de type « wurtzite », présentant un axe « c » (l'axe « c » étant la direction perpendiculaire au plan dans lequel la structure présente la symétrie hexagonale). La flèche « N-Dir » indique la direction d'orientation des liaisons azote-gallium orientées le long de l'axe « c » des couches de nitrure de gallium. Comme indiqué sur la figure, les couches de nitrure de gallium présentent vers le haut leurs faces de désignation cristallographique (000-1) parfois dites « faces azote ».

La figure 2 illustre en (B) un exemple de dispositif GaN vertical V.Dev, ici un transistor à effet de champ, pouvant être obtenu aisément à partir de la structure illustrée en (A). Comme indiqué sur la figure, les couches de nitrure de gallium présentent vers le haut leurs faces de désignation cristallographique (000-1).

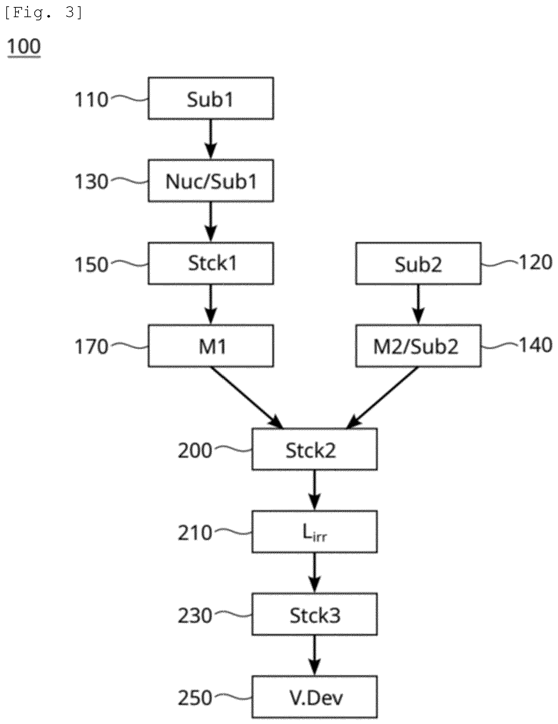

La figure 1 et la figure 3 illustrent un procédé 100 de fabrication de la structure Struct selon l'invention.

A une étape 110, un premier substrat Sub1 est fourni. Il peut s'agit d'un substrat de saphir, tel qu'un wafer, de préférence présentant une orientation C et poli sur ses deux faces.

A une étape 130, une couche de GaN de nucléation est formée sur une face du premier substrat Sub1. Cette couche peut être formée par ALD (Atomic Layer Deposition en terminologie anglaise, qui peut se traduire par dépôt de couche atomique en français) et plus spécifiquement par Remote Plasma Atomic Layer Deposition en terminologie anglaise (dépôt de couche atomique par plasma à distance). On peut ainsi former une couche de GaN de nucléation de 10 à 40 nm d'épaisseur, la face libre de cette couche étant une face de désignation cristallographique (0001) parfois dite « face gallium » de la couche de GaN.

Cette couche de nucléation a pour but de favoriser une structure cristalline de bonne qualité lors des étapes suivantes de formation de couches de GaN par épitaxie.

L'étape 130 peut également comprendre un traitement thermique par chauffage de la couche de nucléation à 1130°C pendant deux heures, par exemple dans une atmosphère comprenant l'un ou une pluralité de H₂, NH₃, N₂, comme par exemple un gaz NH₃/N₂ à 80% de NH₃.

A une étape 150, on forme successivement par épitaxie un empilement Stck1 composé d'une pluralité de couches de GaN, dont la première est formée en contact direct avec la couche de nucléation Nuc. Les couches sont formées de manière telle que chacune des couches de gallium de l'empilement Stck1 est formée sur et en contact direct avec une face de désignation cristallographique (0001) d'une couche de GaN précédemment déposée. Ainsi, chacune des couches de GaN de l'empilement Stck1 et de la couche de GaN de nucléation Nuc présente naturellement, juste après sa formation, une face libre de désignation cristallographique (0001).

La formation de l'empilement Stck1 comprend, dans cet ordre, la formation par épitaxie d'une première couche GaN(n+)_1 de GaN de type n+ (épaisseur comprise entre 0,2 et 2 micromètres), d'une couche GaN(p-) de GaN de type p- (épaisseur comprise entre 0,1 et 1 micromètres), d'une couche GaN(n-)_DL de GaN de type n-(épaisseur comprise entre 1 et 30 micromètres), et d'une seconde couche GaN(n+)_2 de GaN de type n+ (épaisseur comprise entre 0,2 et 2 micromètres). Les indications « p » et « n » indiquent un type de dopage, de type p ou de type n, du GaN. Les indications « + » et « - » indiquent des concentrations relatives d'éléments dopant. Ainsi, une couche avec une indication n+ contient une plus grande concentration de dopant de type n qu'une couche avec une indication n-, et une couche avec une indication p+ contient une plus grande concentration de dopant de type p qu'une couche avec une indication p-. Il est difficile de définir des gammes de valeurs pour ces concentrations, celles-ci dépendant des applications visées. On peut cependant donner un exemple de GaN de type n dopé au Si, pour lequel des valeurs des concentrations de dopages (i) « n+ », et (ii) « n- » peuvent correspondre respectivement à des concentrations (i) supérieure à 2.10¹⁸ at/cm³, et (ii) allant de 1.10¹⁵ à 1.10¹⁷ at/cm³. Similairement, on peut donner un exemple de GaN de type p dopé au Mg, pour lequel des valeurs des concentrations de dopages (i) « p+ », et (ii) « p- » peuvent correspondre respectivement à des concentrations (i) supérieure à 3.10¹⁹ at/cm³, et (ii) allant de 1.10¹⁷ à 1.10¹⁸ at/cm³.

Il est important de noter que la première couche GaN(n+)_1 formée sur la couche de nucléation Nuc doit avoir une épaisseur supérieure à celle qu'elle devra avoir dans la structure Struct achevée. En effet, lors d'une étape ultérieure, une partie de cette couche sera éliminée afin d'obtenir un état de surface satisfaisant et un bon état cristallin de la partie restante. Son épaisseur après sa formation doit donc représenter la somme de son épaisseur souhaitée dans la structure Struct et de l'épaisseur Thck qu'il est prévu d'éliminer (lors de l'étape 230 détaillée plus bas).

A une étape 170, une première couche métallique M1 de collage est formée sur l'empilement Stck1, de préférence de manière à former un contact ohmique avec la dernière couche GaN(n+) _2 formant le stack. Il peut s'agir d'une bicouche Ti/Al, le titane étant en contact avec la couche GaN(n+)_2. Cette première couche métallique peut être formée par exemple par PVD (Physical Vapor Deposition en terminologie anglaise) ou encore par sputtering, ou toute autre méthode de dépôt connue de l'homme du métier.

En parallèle aux étapes 110 à 170, un second substrat Sub2 est fourni à une étape 120. Ce second substrat peut être un wafer de carbure de silicium SiC, de préférence un wafer de carbure de silicium polycristallin pSiC de type n+. On peut par exemple employer du carbure de silicium polycristallin dopé à l'azote, présentant une résistivité électrique inférieure à 10 mOhm.cm, préférablement inférieure à 5 mOhm.cm, plus préférablement inférieure à 2 mOhm.cm, Un substrat de ce type, de forte conductivité thermique, permet une meilleure gestion thermique d'un dispositif semiconducteur formé à partir de la structure Struct : il favorise l'évacuation de la chaleur produite par le dispositif en fonctionnement. En outre, comparativement au silicium, il présente une faible différence de coefficient de dilatation thermique avec le GaN et une conductivité électrique élevée, le rendant très avantageux pour les applications de haute puissance qui nécessitent un courant élevé, des températures élevées et une forte conductivité thermique. Alternativement, d'autres types de substrats, tels que ceux couramment utilisés dans l'industrie des semiconducteurs pourraient âtre utilisés, l'invention ne se limitant pas au SiC.

A une étape 130, une seconde couche métallique M2 de collage est formée sur le second substrat Sub2, de manière similaire à la couche M1 formé sur l'empilement Stck1.

A une étape 200, le premier empilement Stck1 est assemblé au second substrat Sub2 par mise en contact direct et collage métallique, ou métal-métal, des deux couches métalliques M1 et M2 de collage. Un deuxième empilement Stck2 est ainsi obtenu, comprenant les deux substrats Sub1 et Sub2 ainsi que l'ensemble des couches formées sur ces substrats et comprises entre eux.

Le principe de l'assemblage est de mettre les deux couches métalliques en contact intime et de chauffer l'ensemble ainsi formé à une température, comprise par exemple, pour un collage entre deux couches M1, M2 en aluminium, entre 500 et 600°C, par exemple 500°C, pour une durée comprise entre 1h et 4h, dans une atmosphère inerte ou réductrice. Le collage est ainsi définitif.

Il est à noter que la température et la durée du recuit d'assemblage est susceptible de varier en fonction de la nature du ou des métaux considérés, par exemple dans le cas d'un collage cuivre-cuivre on choisira typiquement un recuit entre 300 et 400°C pour 1 à 4h.

A une étape 210, le premier substrat Sub1 est détaché de l'empilement Stck1 au niveau de la couche de nucléation Nuc par irradiation lumineuse à travers le premier substrat Sub1 et absorption de cette irradiation par la couche de nucléation Nuc. L'absorption d'énergie par la couche Nuc dégrade celle-ci et induit le détachement. L'irradiation lumineuse peut être effectuée par irradiation laser, en employant une longueur d'onde à laquelle le premier substrat Sub1 est sensiblement transparent et la couche de nucléation est sensiblement absorbant. On peut par exemple employer un laser KrF avec une longueur d'onde de 248 nm et des largeurs d'impulsion de 40 ns. Il peut s'agir d'une procédure dite LLO, Laser Lift Off en terminologie anglaise. L'irradiation lumineuse est également absorbée sur quelques dizaines de nanomètres d'épaisseur par la couche de GaN GaN(n+)_1.

Au cours de l'étape 210 de détachement du premier substrat, la couche de nucléation Nuc a été détériorée par l'irradiation lumineuse. Il convient d'éliminer les restes de cette couche de nucléation.

La partie de la première couche GaN(n+)_1 en contact avec la couche de nucléation a également été détériorée lors de l'étape de détachement du premier substrat. En outre, indépendamment de l'étape de détachement, la partie de la première couche GaN(n+)_1 la plus proche de la couche de nucléation Nuc est souvent de qualité cristalline inférieure à celle la partie de la première couche GaN(n+)_1 la plus éloignée de la couche de nucléation Nuc. Afin de ne conserver qu'une partie de la première couche GaN(n+)_1 de haute qualité cristalline, il convient d'éliminer une certaine épaisseur de cette couche.

A une étape 230, la couche de nucléation Nuc et une partie de la première couche GaN(n+)_1 sont éliminées, éventuellement par une attaque plasma ou par une opération de polissage telle qu'une opération de CMP, Chemical Mechanical Polishing en terminologie anglaise : l'opération de CMP est appliquée (i) à la totalité de l'épaisseur de la couche de nucléation Nuc, ou de ce qu'il en reste apprès l'étape de détachement 210, et (ii) à une certaine épaisseur Thck de la première couche GaN(n+)_1, environ 50 nm par exemple. A la suite de l'étape 230, un empilement Stck3 est obtenu, s'étendent du second substrat Sub2 à la première couche GaN(n+)_1 amincie, comme illustré en (A) de la figure 2.

A cette étape, l'empilement Stck3 peut en principe servir de base de fabrication de divers dispositifs GaN verticaux. Une étape 250 de fabrication d'un tel dispositif peut mener à un dispositif Gan vertical V.Dev tel que le transistor à effet de champ illustré en (B) de la figure 2.

L'étape 250 peut comprendre les étapes (i) de formation d'une électrode de drain D sur une face libre du second substrat Sub2, (ii) de formation d'une électrode de source S sur une face libre de la première couche de GaN de type n+ (GaN(n+)_1), et (iii) de formation d'une structure de grille traversant la première couche GaN(n+)_1, la couche GaN(p-), et en contact avec la couche GaN(n-)_DL. La couche GaN(n-)_DL a alors la fonction d'une couche de dérive, Drift Layer en terminologie anglaise. La structure de grille comprend une électrode de grille G électriquement isolée des couches GaN(n+)_1, GaN(p-) et GaN(n-)_DL par une couche GI de diélectrique de grille.

Dans ce document, les figures ne sont pas nécessairement à l'échelle. Certaines caractéristiques et certains composants peuvent être représentés exagérés par rapport à d'autres composants ou sous une forme quelque peu schématique, et certains détails d'éléments conventionnels peuvent ne pas être représentés dans l'intérêt de la clarté et de la concision.

Bien entendu l'invention n'est pas limitée aux modes de mise en œuvre décrits et on peut y apporter des variantes de réalisation sans sortir du cadre de l'invention tel que défini par les revendications.

## Revendications

1. Procédé de fabrication d'une structure (Stck3) comprenant une pluralité de couches de GaN (GaN(n+)_1, Gan(p-), GaN(n-)_DL, GaN(n+)_2)), cette structure étant prévue pour former un dispositif GaN vertical, comprenant les étapes de :
- fournir (110) un premier substrat (Sub1) ;
- former (130) une couche de GaN de nucléation (Nuc) sur une face du premier substrat (Sub1) ;
- sur la couche de GaN de nucléation (Nuc), former (150) par épitaxie un empilement (Stck1) comprenant, dans cet ordre, une couche de GaN de type n+ (GaN(n+)_1), une couche de GaN de type p- (GaN(p-)), une couche de GaN de type n-(GaN(n-)_DL), et une seconde couche de GaN de type n+ (GaN(n+)_2);
- sur l'empilement (Stck1), former (170) une première couche métallique (M1) de collage ;
- fournir (120) un second substrat (Sub2) ;
- sur le second substrat (Sub2), former (140) une seconde couche métallique (M2) de collage ;
- assembler (200) l'empilement (Stck1) au second substrat (Sub2) par mise en contact direct et collage métallique des deux couches métalliques (M1, M2) de collage ;
- détacher (210) le premier substrat (Sub1) de l'empilement (Stck1) au niveau de la couche de nucléation (Nuc) par irradiation lumineuse à travers le premier substrat (Sub1) et absorption de cette irradiation par la couche de nucléation (Nuc) ; et
- éliminer (230) la couche de nucléation (Nuc).

2. Le procédé de fabrication selon la revendication 1, dans lequel le second substrat est formé de carbure de silicium polycristallin.

3. Le procédé de fabrication selon la revendication 1 ou 2, dans lequel l'étape d'éliminer (230) la couche de nucléation (Nuc) comprend également une élimination d'une partie de celle (GaN(n+)_1) des couches de GaN qui a été formée en contact direct avec la couche de nucléation (Nuc) .

4. Le procédé selon l'une quelconque des revendications 1 à 3, dans lequel l'étape d'éliminer (230) la couche de nucléation est mise en œuvre par polissage mécano-chimique.

5. Le procédé selon l'une quelconque des revendications 1 à 4, dans lequel la couche de GaN de nucléation (Nuc) a une face libre de désignation cristallographique (0001).

6. Le procédé selon l'une quelconque des revendications 1 à 5, dans lequel, la couche de nucléation est formée par ALD - Atomic Layer Deposition en terminologie anglaise.

7. Le procédé selon l'une quelconque des revendications 1 à 6, dans lequel chacune des couches de GaN ((GaN(n+)_1, Gan(p-), GaN(n-)_DL, GaN(n+)_2))) de l'empilement (Stck1) est formée sur et en contact direct avec une face de désignation cristallographique (0001) d'une couche de GaN précédemment déposée (Nuc, GaN(n+)_1, Gan(p-), GaN(n-)_DL) .

8. Le procédé selon l'une quelconque des revendications 1 à 7, dans lequel chacune des couches de GaN ((GaN(n+)_1, Gan(p-), GaN(n-)_DL, GaN(n+)_2))) de l'empilement (Stck1) et de la couche de GaN de nucléation (Nuc) est formée de manière à présenter, juste après sa formation, une face libre (T.Surf) de désignation cristallographique (0001).

9. Le procédé selon l'une quelconque des revendications 1 à 8, dans lequel le premier substrat (Sub1) est un wafer de saphir.

10. Le procédé selon l'une quelconque des revendications 1 à 9, dans lequel le second substrat (Sub2) est un wafer de carbure de silicium, de préférence un wafer de carbure de silicium polycristallin de type n+ présentant une résistivité électrique inférieure à 10 mOhm.cm.

11. Procédé de formation d'un transistor comprenant le procédé selon l'une quelconque des revendication 1 à 10, et comprenant en outre l'étape (250) de former :
- une électrode de drain (D) sur une face libre du second substrat ;
- une électrode de source (S) sur une face libre de la première couche de GaN de type n+ (GaN(n+)_1) ; et
- une structure de grille traversant la première couche de GaN de type n+ (GaN(n+)_1), la couche de GaN de type p- (GaN(p-)), et en contact avec la couche de GaN de type n- (GaN(n-)_DL) .
